# EUROPEAN PATENT APPLICATION

(11) **EP 4 660 700 A1**
(43) Date of publication of application: **10.12.2025**
(21) Application number: 24179499.9
(22) Date of filing: 03.06.2024
(51) Int. Cl.: G03F 7/00

(54) **SUPPRESSION OF PLASMA-INDUCED SURFACE DEGRADATION BY IRRADIATION OF LIGHT**

(71) Applicant: ASML Netherlands B.V., 5500 AH Veldhoven (NL)
(72) Inventor: VAN DE KERKHOF, Marcus, Adrianus, 5500 AH Veldhoven (NL)
(74) Representative: ASML Netherlands B.V.

(57) **Abstract**

An exposure apparatus comprising:
an enclosure defining an environment, wherein the enclosure is configured to receive a main radiation from a main radiation source and to contain a plasma, wherein the enclosure comprises a plasma-facing surface;
an additional radiation source configured to generate an additional radiation with wavelength of 300 nm or more and configured to irradiate at least a portion of said plasma-facing surface to generate electrons when the plasma is present.

## Description

### FIELD

The present invention relates to an exposure apparatus for semiconductor manufacturing process, and a method to suppress plasma-induced surface degradation in said apparatuses.

### BACKGROUND

Radiation generated by means of a radiation source can be used by exposure apparatuses for semiconductor manufacturing processes. Examples of such exposure apparatuses are a lithographic apparatus, a metrology apparatus, or an inspection apparatus, such as a wafer inspection apparatus and/or a mask inspection apparatus, such as an actinic mask inspection apparatus. While elements of this disclosure focus on extreme ultraviolet (EUV) radiations, aspects and embodiments of this may also be applicable to other wavelengths, including but not limited to soft X-ray, DUV and broadband radiation. Aspects and embodiments of this disclosure may also be applicable to particle radiation, such as electron beam radiation or ion beam radiation.

A lithographic apparatus is a machine constructed to apply a desired pattern onto a substrate. A lithographic apparatus can be used, for example, in the manufacture of integrated circuits (ICs). A lithographic apparatus may, for example, project a pattern from a patterning device (e.g., a mask) onto a layer of radiation-sensitive material (e.g., a photoresist or resist) provided on a substrate. To project a pattern on a substrate a lithographic apparatus may use electromagnetic radiation. The wavelength of this radiation determines the minimum size of features which can be formed on the substrate. A lithographic apparatus, which uses EUV radiation, having a wavelength within the range 4-20 nm, for example 6.7 nm or 13.5 nm, may be used to form smaller features on a substrate than a lithographic apparatus which uses, for example, radiation with a wavelength of 193 nm.

An (actinic) mask inspection apparatus is an apparatus that is configured for measuring dimensions or detecting defects in masks or mask blanks. EUV lithography uses a reflective surface instead of lenses as optics. Mask blanks used in EUV lithography generally have a multilayer structure which functions as a Bragg reflector, the multilayers may be alternatingly Molybdenum and Silicon. If a defect exists in this structure, the projected pattern will be deformed in the lithographic process. Therefore, mask inspection to check whether a defect is present is considered a requirement for a mass-production process. EUV mask inspection may be used for several purposes and in several different stages. Firstly, it can be used for the detection of phase defects that may occur in mask blanks. Such phase defects may occur during the manufacturing of the multilayer stack of the mask blank. If undetected, these phase defects are printed on all chips printed with the part of a mask containing the phase defects. Such phase defects may be correctly detected by using the same or similar (13.5nm) actinic EUV wavelength as used by the lithography tool. Secondly, mask inspection can be used for patterned mask inspection and can be carried out for quality control of EUV patterned masks. For example, the mask inspection can be used to measure critical dimensions on the mask blank. In addition to phase defects, absorber pattern defects on the surface can be detected. Thirdly, mask inspection may be used to mimic exposure by a lithographic apparatus and determine the deterioration of optical contrast of a defect detected in the actinic inspection. Forth, the mask inspection can be used for optical proximity correction (OPC) evaluation or during mask repair process so as to improve pattern transfer fidelity. Further, it can be used for inspecting optical contrast after fixing the defect. In addition to the above, mask inspection can also be used to measure small particle/amplitude effects.

An exposure apparatus, such as a lithographic apparatus, may use an EUV radiation source. Once the EUV radiation has been generated, it is directed through the lithographic apparatus by a plurality of optical components, such as mirrors, to a patterning surface of the patterning device, which imparts the desired pattern to the EUV radiation. Other components, such as sensors and detectors, may also be present in the lithographic apparatus. Surface degradation of the optical components can undesirably impair the properties of these components, for example reducing the reflectivity of the mirrors for the EUV radiation. Surface degradation of other components can undesirably damage these components, for example reducing the performance and/or the operational efficiency of the component. Thus, surface degradation of certain components of the lithographic apparatus should be avoided or mitigated.

Surface degradation may be caused by, for example, the chemical reaction of ions or contaminants with the component surface. Gas purging might be used to prevent or mitigate surface degradation of components, however the gas may also end up being a source of contamination as it may react with other materials and/or with the EUV light, forming compounds that may degrade the components. In the case of EUV light incident on a residual gas, a plasma may be formed. The ionic plasma species and the electrons generated from the plasma formation may be detrimental to the plasma-facing surfaces of components, by inducing effects such as surface contamination, oxidation, and/or ion implantation.

### SUMMARY

An aim of the present invention is to provide an effective technique of suppression of plasma-induced surface damage on components in exposure apparatuses, such as EUV lithography systems.

According to an aspect of the present invention, there is provided an exposure apparatus comprising:
an enclosure defining an environment, wherein the enclosure is configured to receive a main radiation from a main radiation source and to contain a plasma, wherein the enclosure comprises a plasma-facing surface;
an additional radiation source configured to generate an additional radiation with wavelength of 300 nm or more and configured to irradiate at least a portion of said plasma-facing surface to generate electrons when the plasma is present.

According to another aspect of the present invention, there is provided a method to suppress plasma-induced degradation on a plasma-facing surface of a component of an exposure apparatus configured to receive a main radiation from a main radiation source and to contain a plasma, the method comprising:
receiving the main radiation, the main radiation interacting with a residual gas and generating the plasma;
generating an additional radiation with a wavelength of 300nm or more, wherein the additional radiation irradiates at least a portion of the plasma-facing surface to generate electrons.

### BRIEF DESCRIPTION OF THE DRAWINGS

Embodiments of the invention will now be described, by way of example only, with reference to the accompanying schematic drawings, in which:
Figure 1 schematically depicts a lithographic system comprising a lithographic apparatus and a radiation source according to the invention;
Figure 2 schematically depicts a system for (actinic) mask inspection according to the invention;
Figure 3 schematically depicts an alternative radiation source according to the invention;
Figures 4 (a) and 4 (b) depicts a schematic view of the principles according to the invention;
Figure 5 depicts a schematic view of how the presence of plasma alters the work function of a plasma-facing surface of a component;
Figures 6 (a) and 6 (b) schematically depict other arrangements according to the invention for an additional radiation source projected onto a plasma-facing surface of a component in the exposure apparatus, wherein the additional radiation source can be located inside or outside of the enclosure of the exposure apparatus.
Figure 7 depicts a flowchart of the method according to the invention.

The features shown in the Figures are not necessarily to scale, and the size and/or arrangement depicted is not limiting. It will be understood that the Figures include optional features which may not be essential to the invention. Furthermore, not all of the features of the apparatus are depicted in each of the figures, and the Figures may only show some of the components relevant for describing a particular feature.

### DETAILED DESCRIPTION

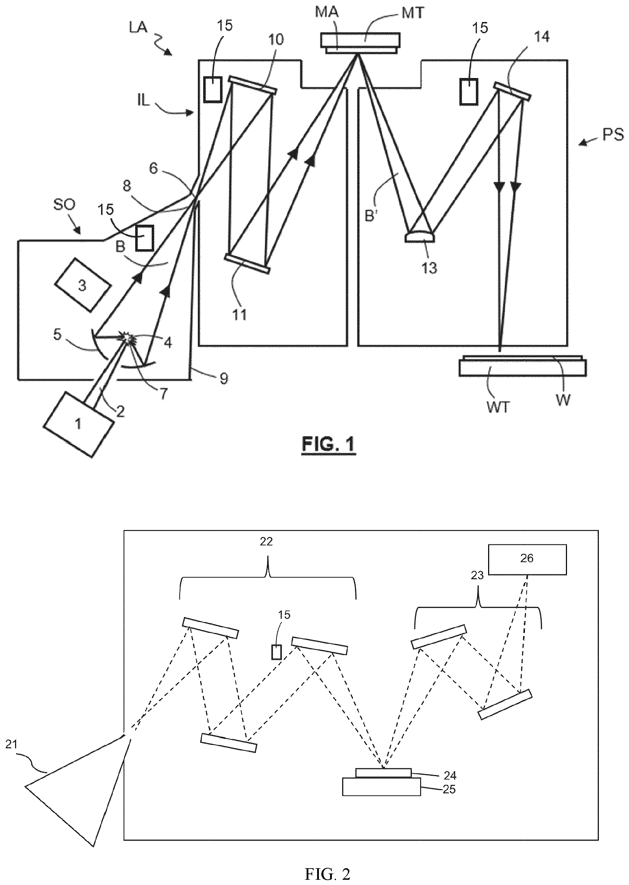

Figure 1 shows a lithographic system comprising a radiation source SO, also referred to as a main radiation source, and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

The lithographic system may include various types of optical components, such as refractive, reflective, magnetic, electromagnetic, electrostatic or other types of optical components, or any combination thereof, for example for directing, shaping, and/or controlling radiation. The lithographic system may also include other components, such as sensors, detectors, actuators, structural components, construction materials, etc.

A relative vacuum, i.e. a small amount of gas (e.g. hydrogen) at a pressure well below atmospheric pressure, may be provided in the radiation source SO, in the illumination system IL, and/or in the projection system PS. Such gas may be referred to as purge gas. Typically, the purge gas is molecular hydrogen, with a pressure of e.g. between about 1 and 10 Pa. The purge gas may also contain other elements or other molecules containing for instance oxygen, nitrogen and carbon.

Contaminant particles may also be present in the environment of the radiation source SO, in the illumination system IL, and/or in the projection system PS. The contaminant particles may be originated for example by friction between moving parts. Contaminant particles may also be introduced during manufacturing of components of the lithographic system, and/or during assembly of the lithographic system. Also, contaminant particles from various sources may be produced during the operation of the lithographic system. For example, surfaces within the lithographic apparatus may release one or more chemicals (e.g. silanes) into an internal environment of the lithographic apparatus. Thus, a residual gas might be present in the lithographic system, which can be composed of the purge gas, the contaminant particles, or the combination and/or reaction products of the purge gas with the contaminant particles.

The lithographic apparatus LA and radiation source SO described herein can be used in a semiconductor device manufacturing method. This method comprises receiving a substrate with a photoresist layer. The method further comprises directing (EUV) radiation from radiation source to the photoresist layer to transfer a pattern from a mask onto the photoresist layer and removing a portion of the photoresist layer to form the pattern over the substrate.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel (i.e., a target material), such as tin (Sn) which is provided from, e.g., a fuel supply system 3. Although tin is referred to in the following description, any suitable fuel may be used. The fuel may, for example, be in liquid form, and may, for example, be a metal or alloy. The fuel supply system 3 may comprise a nozzle configured to direct the fuel, e.g. in the form of droplets, along a trajectory towards a source plasma formation region 4. The laser beam 2 is incident upon the fuel at the source plasma formation region 4. The deposition of laser energy into the tin creates a source plasma 7 at the source plasma formation region 4. Radiation, including EUV radiation, is emitted from the source plasma 7 during de-excitation and recombination of electrons with ions of the source plasma 7.

The EUV radiation from the source plasma 7 is collected and focused by a reflective surface 5. According to embodiments the reflective surface is a collector. The collector comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the source plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the source plasma present at the source plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a free electron laser (FEL) or a discharge produced plasma (DPP) source may be used to generate EUV radiation.

According to an embodiment of the invention, an additional radiation source 15 may be placed within the main radiation source SO and/or within the lithographic apparatus LA. Figure 1 shows the additional radiation source 15 placed within the main radiation source SO, within the illumination system IL, and within the projection system PS, as examples of possible embodiments according to the invention.

Figure 2 depicts a system for (actinic) mask inspection. A mask inspection system can be used to identify or inspect defects in a mask to be used in a lithographic process by means of an apparatus described in figure 1. The mask inspection system comprises an radiation source 21 and an illumination system 22 and a detection system 23. A mask 24 is placed on a mask stage 25 and illuminated by the illumination system 22 reflecting radiation incident from the radiation source. The radiation coming from the illuminated mask is reflected by the detection system. In this way an image is formed on a detector 26. According to an embodiment of the invention, Figure 2 shows an additional radiation source 15 placed within the (actinic) mask inspection system.

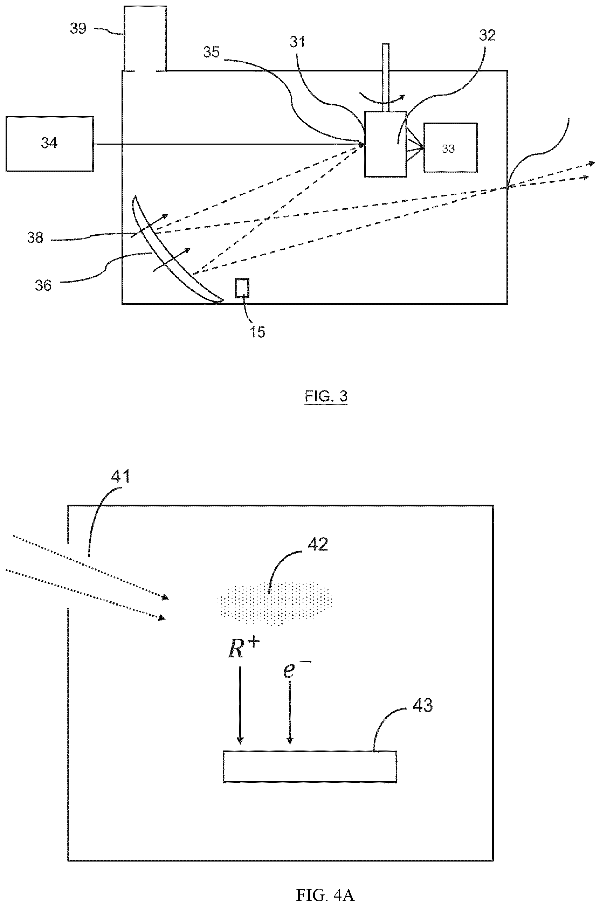

Figure 3 depicts an alternative radiation source. For generating source plasma target material 31, like tin or xenon may be provided to a rotating element 32, like for example rotating wheels, cylinder, or a drum or variations thereof. Target material may be provided by a target source 33 in liquified form to the one or more rotating elements, e.g. by means of a target material bath. Alternatively, target material may also be provided in solid or frozen form (e.g. Xenon). Gaseous target material may be sprayed onto the rotating element to replace target material transformed to source plasma. According to embodiments the rotating element would be cold enough to solidify the target material. An excitation device 34 may be used to assist in source plasma formation at a source plasma generation site 35. According to embodiments this excitation device is a laser like a solid-state or gas laser. Reflective surfaces 36, like one or more mirrors can be used to reflect the EUV light generated to the intermediate focus 37. According to embodiments, the reflective surface is a collector mirror. Buffer gas flow 38 may be provided to mitigate debris present in the radiation source. Also a vacuum pump 39 may be provided. According to an embodiment of the invention, Figure 3 shows an additional radiation source 15 placed within the alternative radiation source.

High energy radiation such as EUV radiation may interact with the residual gas in the exposure apparatus, such as a lithographic system, ionizing the residual gas and generating free electrons, thus producing EUV-induced plasma. High energy radiation such as EUV radiation is also referred to as a main radiation.

Plasma is a state of matter in which the constituent atoms and/or molecules are partially ionized, so that the properties of the assembly of the charged particles, such as atoms and/or molecules, are governed to some degree by coulomb interactions. Besides their partial ionization, the particles in the plasma also typically have a significant number of radicals, which may strongly enhance chemical reaction rates.

The components of the exposure apparatus that have surfaces exposed to the plasma are referred to as plasma-facing surfaces. The plasma may react with the constituent materials of these components via their surfaces. The plasma-facing surface may be a surface within the exposure apparatus, such as a panel, a mirror, a detector, and/or a wall of the enclosure of the exposure apparatus.

The free electrons in a plasma have a much higher velocity than the ions, which will initially result in a higher flux of electrons from the plasma towards the plasma-facing surface, and a depletion of electrons close to said surface within the component. Subsequently, the net outflux of electrons from the plasma may result in an electric field that promotes the positively charged ions toward the surface. This results in an equilibrium condition where an electron-depleted sheath region is formed between the plasma and the plasma-facing surface.

In such sheath region, ions may be accelerated to energies of several electron volts (eV). The accelerated ions may be advantageous for some applications, for example in carbon etching by hydrogen plasma, or in deposition processes. However, in most applications, the risk of damage by the energetic ions is considered undesired. Such sheath region may also be referred to as plasma sheath or ion-accelerating sheath.

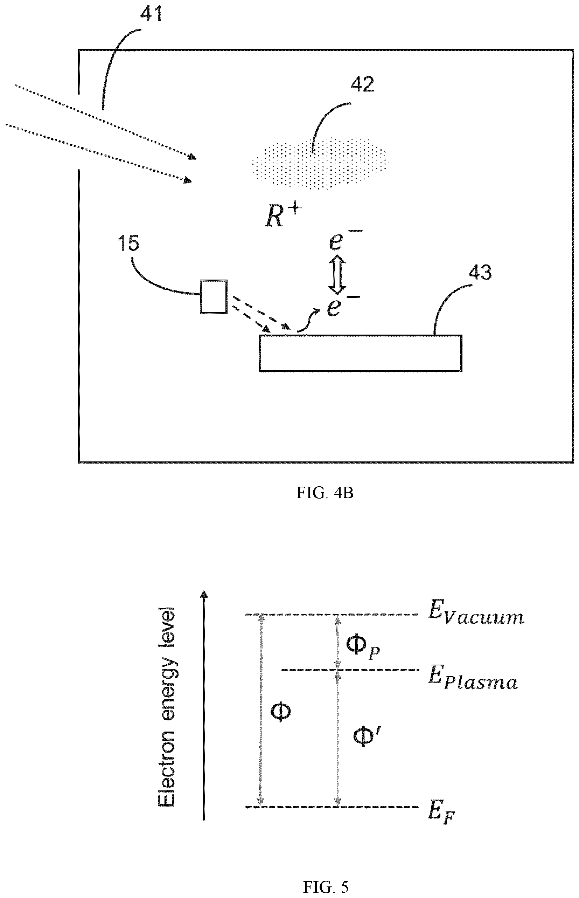

Figures 4 (a) and 4 (b) show a high energy radiation 41, also referred to as a main radiation, irradiating residual gas 42 and generating plasma formed by ionized particles *R*⁺, such as ionized atoms, molecules or radicals, and free electrons *e*⁻. Figure 4 (a) shows that the free electrons and accelerated ions may interact with a plasma-facing surface 43, possibly damaging said surface. The interaction of the ionized particles *R*⁺ and free electrons *e*⁻ with the plasma-facing surface 43 is depicted by the solid arrows in Figure 4a.

In exposure apparatuses, such as lithographic apparatuses or inspection tools, plasma is created in and around the main radiation beam, such as an EUV beam, by irradiation of the residual gas by energetic photons, such as EUV photons. This results in increased chemical reactivity by creating a significant amount of radicals, which have zero or very low activation energies for chemical reactions, plus energetic ions which may further promote chemical reactions, for example by breaking bonds by collisions in plasma-facing surfaces.

The plasma created by the EUV beam radiation interaction with the residual gas may generate charged particles such as hydrogen ions and radicals. Trace components such as N2, O2 and hydrocarbons may also become ionized, and possibly further react and become protonated. The charged particles formed may show strongly increased reaction rates with the plasma-facing surfaces.

A disadvantage of plasma in general may be the risk of damage caused by the highly energetic ions incident on the plasma-facing surface of components.

For lithographic apparatuses specifically, ionized components like HO2+, H3O+, HN2+, N+, etc, are considered a risk for damage, for example to the EUV mirrors, and also to other components, such as sensors, detectors and construction materials exposed to EUV-induced plasma.

Another disadvantage of plasma in contact with a surface is that the negative charge originated from the plasma may accumulate at the plasma-surface interface. The accumulated negative surface charge attracts the positive ions from the component to its surface, and repels the negative ions, such as negatively charged oxygen ions, deeper into the component. Both these effects accelerate and promote deep oxidation.

Thus, the interaction of the EUV radiation with the residual gas may form a plasma and generate particles such as ions and radicals. These generated particles may damage optical components or other components within the lithographic system. For example, the generated particles may deposit and/or react with plasma-facing surfaces, such as those of optical elements. Such reactions may result in damage to the components, for example causing image distortion or loss of reflectivity of the EUV radiation.

Therefore, there is a need to suppress or mitigate or control the reaction of plasma generated particles with plasma-facing surfaces of components within the lithography system.

Although specific reference may be made in this text to the plasma-facing surface reactions of components within the lithographic apparatus, the principles described here may hold for plasma-facing surface interactions in general.

According to the invention, the damage caused by plasma generated particles on the components of the lithographic system may be reduced or suppressed by irradiating the plasma-facing surface of the components with an additional radiation of wavelength of 300 nm and/or above, generated by an additional radiation source. Such wavelengths may correspond for example to visible light or infra-red radiation.

The irradiation of a surface of a component with a radiation of certain wavelengths may induce photoelectric effect, generating an outflux of photoelectrons from such surfaces. The photoelectric effect is the release of an electron from a surface by a photon. In order for this electron to escape from the surface, the photon energy must exceed the work function of the surface. The work function is defined as the minimum thermodynamic work (i.e., energy) needed to remove an electron from the surface of a component to a point in vacuum outside of the surface. The work function is a material surface property, and besides the bulk material it may depend on surface properties such as crystal orientation and roughness.

Photoelectric effect may be beneficial when induced on plasma-facing surfaces, as the photoelectrons released from the components surface may cause deceleration of the high energy electrons originated in the plasma, when these electrons approach said surfaces. This may also reduce, or even stop, the accelerated deep oxidation caused by the negative surface charge region formed on the plasma-facing surface without irradiation. The outflux of photoelectrons from said surfaces may further suppress the formation of the ion-accelerating sheath.

Figure 4 (b) schematically depicts how the invention may suppress plasma-induced surface degradation. According to the invention, the additional radiation source 15 may irradiate the plasma-facing surface 43. The dashed arrows in Figure 4 (b) represent the irradiation of the plasma-facing surface by the additional radiation. Photoelectrons will then be released from said surface, which is schematically indicated in Figure 4 (b) by the curved arrow. The photoelectrons released from the plasma-facing surface interact with the free electrons originated in the plasma, decelerating the free electrons and further suppressing the formation of the ion-accelerating sheath.

According to the invention, the use of an additional radiation with wavelength of 300 nm and/or above may induce the release of photoelectrons from the surface of components under the environment conditions caused by the presence of plasma. While under circumstances such as those considered in classical physics, radiation with such wavelengths would not induce the release of photoelectrons from the surface of components. However, under plasma conditions the potential wall at the edge of the plasma-facing surface will be reduced, or even removed, by the plasma sheath. In such conditions, photoelectrons may be released from plasma-facing surfaces, even when the radiation used is characterized by photon energies of several electron volts below the classical photoelectric threshold value.

In classical physics, occurrence of photoelectric effect requires an incident photon with energy higher than the work function of the material, which typically corresponds to photons of 4 eV or more. Such photon energies correspond to radiation with wavelength of less than 300 nm. However, the presence of a plasma lowers this required photon energy, potentially even to almost zero, and thus photoelectric effect can be induced on plasma-facing surfaces by the use of radiation with wavelength of 300 nm or more. Photons of radiation with wavelength of 300nm or more may be referred to as low-energy photons.

Figure 5 depicts a schematic view of how the presence of plasma alters the work function of a plasma-facing surface of a component. The work function Φ is the difference between the electron energy level *E_{F}* inside the component and the electron energy level in vacuum *E_{Vacuum}.* The presence of plasma lowers the required energy for an electron to be released from the surface of the component. In the presence of plasma, the electron energy level *E_{Plasma}* is lower than the electron energy level in vacuum *E_{Vacuum}.* The difference between the electron energy level in vacuum and the electron energy level in plasma is represented by Φ_{P} in Figure 5. In the presence of plasma, the work function Φ' is reduced by Φ_{P} when compared to the work function Φ needed to remove an electron from the surface of a component to a point in vacuum. Thus, when the surface of a component is a plasma-facing surface, the minimum energy required to release an electron from the plasma-facing surface is Φ' = Φ - Φ_{P}.

When the component surface is in contact with a plasma, the thermodynamic work required to remove an electron from the surface to a point within the plasma is lower than the work required to bring the electron from the surface to vacuum, since the plasma has a slight net positive charge (which is caused by the more mobile electrons escaping somewhat faster to the surrounding surfaces), resulting in a plasma potential Φ_{P}. For example, the resulting plasma potential may be between 1 and 2 eV. The resulting effective work function in presence of plasma is thus, in such example, between 1 and 2 eV smaller than the resulting work function without the presence of plasma. This also reduces the minimum photon energy for the photoelectric effect to occur by, in such example, between 1 and 2 eV, shifting the typical threshold wavelength range, for example from 200-250 nm to ~400-500 nm.

The incidence of low-energy photons on a plasma-facing surface will result in an outflux of electrons from the surface into the plasma, which will decelerate the high energy electrons generated in the plasma, and thus suppress the formation of an ion-accelerating sheath. The electrons emitted by the plasma-facing surface may also be called low-energy photoelectrons, or photoelectrons.

Incidence of low-energy photons of up to 2um of wavelength on a plasma-facing surface will result in an outflux of electrons from the surface into the plasma, and thus suppress the formation of an ion-accelerating sheath. Low-energy photons from an additional radiation with wavelength above 2um will not have sufficient energy to generate photoelectrons from the plasma-facing surface.

The use of said radiation of wavelength of 300 nm or more, such as visible and/or infra-red wavelengths, has major advantages for lithography systems, such as:
1. These wavelengths may be used freely at any intensity without risk of exposing the photoresist layer provided on a substrate, which is typically sensitive to radiation with wavelengths below 300 nm;
2. Sources of radiation with wavelengths of 300 nm or more are universally available at a wide range of power levels and form factors and may require little power, allowing for easy system integration. It should be noted that in the context of a lithographic apparatus, a few radiation sources of 1 W (at approximately 10¹⁸ photons per second each) could already result in approximately 10¹⁸ photoelectrons released from a plasma-facing surface, which could for instance effectively suppress sheath formation for all mirrors in the projection system PS;
3. Sources of radiation of wavelength of 300 nm or above may have a lifetime as long as that of a lithographic apparatus, even at 100% duty cycle operation.
4. Radiation with wavelength of 300 nm or above will not ionize gaseous molecules in the residual gas, and thus will not create additional ions.

This invention can also be beneficial to the overall design of exposure apparatuses, which can for instance use lighter materials since there would be less need to have robust layers that can sustain plasma-induced degradation. An example is the use of lighter and/or less robust construction materials used in the exposure apparatuses.

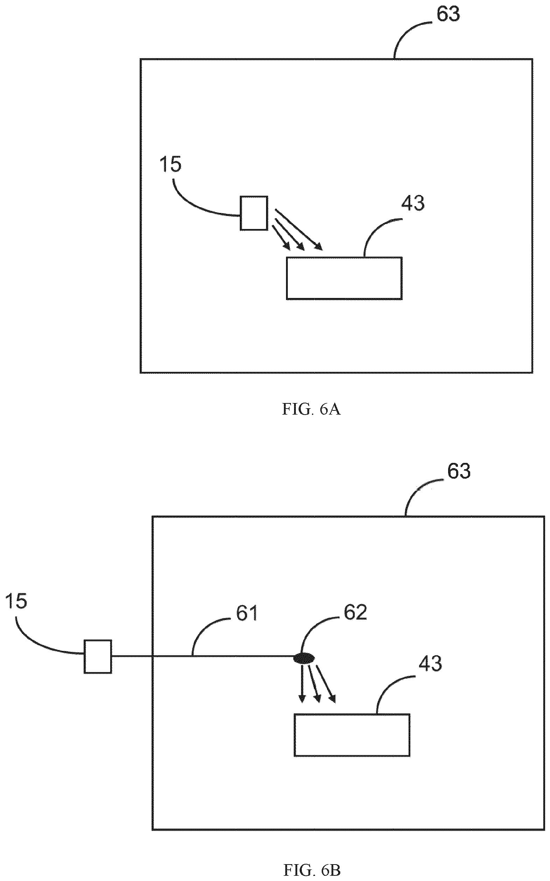

Figure 6 schematically depicts another arrangement according to the invention for an additional radiation source 15 projected onto a plasma-facing surface 43 of a component in the exposure apparatus, wherein the additional radiation source may be located within the enclosure 63 of the exposure apparatus (Figure 6 (a)), and/or outside the enclosure of the exposure apparatus (Figure 6 (b)). The incidence of low-energy photons on the plasma-facing surface is depicted in Figures 6 (a) and 6 (b) by the solid arrows. The additional radiation source may be located at a distance from the plasma-facing surface, and in such case the low-energy photons may be delivered to the plasma-facing surface by, for example, a guiding structure for guiding the additional radiation to the plasma-facing surface, and/or a device for delivering the radiation to the plasma-facing surface. The guiding structure can be for example one or multiple optical fibers or one or multiple mirrors. The device for delivering the radiation can be for example one or multiple LED lamps. Figure 6 (b) shows the additional radiation source placed outside the enclosure 63 of an exposure apparatus, an optical fiber 61 and a LED lamp 62.

The additional radiation may also be directed and/or shaped before it reaches the plasma-facing surface, for instance by the use of lens elements and/or mirrors.

A preferred embodiment may comprise an additional radiation source placed outside the enclosure of an exposure apparatus, an optical fiber to guide the additional radiation to a plasma-facing surface, a LED lamp and lens elements to deliver a shaped beam to a portion of a plasma-facing surface.

This invention foresees the use of one or multiple sources of the additional radiation with wavelength of 300 nm or above, to irradiate one or multiple plasma-facing surfaces of the exposure apparatus. The source or sources of radiation may irradiate radiation of a given wavelength, and/or different wavelengths, and/or within a broadband. The radiation may be used continuously, in intervals, and/or in pulses.

Furthermore, heating and/or cooling systems may also be used in addition to the radiation of wavelength of 300 nm or above in order to heat or cool a component of the exposure apparatus. Detectors and sensors may also be used in addition to the invention, for example in order to monitor the amount of photoelectrons being emitted by the plasma-facing surface and use the information from the monitoring in order to control the radiation of the additional radiation source.

Plasma may also be used to clean, etch or implant ions on a surface. This invention, and/or the embodiments described in this invention, may also be applied to control cleaning, etching, or ion implantation on a plasma-facing surface.

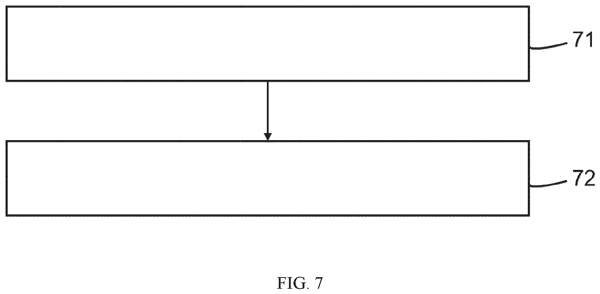

A flowchart of the method according to the invention is shown in Figure 7. Figure 7 shows a method to suppress plasma-induced degradation on a plasma-facing surface within an enclosure of an exposure apparatus, the enclosure configured to receive a main radiation from a main radiation source and to contain a plasma, the method comprising: receiving the main radiation, the main radiation interacting with a residual gas in the enclosure and generating the plasma (71); generating an additional radiation with a wavelength of 300nm or more, wherein at least a portion of the additional radiation is configured to irradiate the plasma-facing surface to generate electrons (72).

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, the embodiments of the invention may be used in other exposure apparatus, including but not limited to mask inspection apparatus, metrology apparatus, or any apparatus that inspects, measures or processes an object such as a wafer (or other substrate) or mask (or other patterning device). These apparatuses may be generally referred to as exposure apparatuses. Such an exposure apparatus may use vacuum conditions, and/or reduced pressure below atmospheric pressure. The embodiments of this invention may also be used to mitigate spurious damage caused by energetic ions in plasma chambers used in other applications, not being restricted to exposure apparatuses.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An exposure apparatus comprising:
an enclosure defining an environment, wherein the enclosure is configured to receive a main radiation from a main radiation source and to contain a plasma, wherein the enclosure comprises a plasma-facing surface;
an additional radiation source configured to generate an additional radiation with wavelength of 300 nm or more and configured to irradiate at least a portion of said plasma-facing surface to generate electrons when the plasma is present.

2. The exposure apparatus of claim 1, wherein the plasma is generated by the interaction of the main radiation with a residual gas within said environment.

3. The exposure apparatus of claim 1 or claim 2, wherein the additional radiation source is configured to generate radiation having a wavelength of 400nm or more.

4. The exposure apparatus of any proceeding claim, wherein the additional radiation source is configured to generate radiation having a wavelength shorter than 2um.

5. The exposure apparatus of any proceeding claim, wherein the additional radiation source is configured to generate radiation in pulses.

6. The exposure apparatus of any proceeding claim, wherein the main radiation source is configured to generate radiation with a wavelength shorter than 100nm, or shorter than 50nm, or shorter than 20nm, or 13.5nm.

7. The exposure apparatus of any proceeding claim, wherein the main radiation is EUV radiation, or soft x-ray radiation, or charged particles radiation, or electron beam radiation.

8. The exposure apparatus of any proceeding claim, wherein the additional radiation source is located within the enclosure.

9. The exposure apparatus of any of claims 1-7, wherein the additional radiation source is located outside the enclosure.

10. The exposure apparatus of claim 9, wherein the additional radiation source comprises one or multiple guiding structures for guiding the additional radiation to the plasma-facing surface, and/or comprises one or multiple devices for delivering the radiation to the plasma-facing surface.

11. The exposure apparatus of any of claims 1-10, wherein the plasma-facing surface is a plasma-facing surface of a mirror, and/or a reticle, and/or a wafer, and/or a sensor, and/or any other plasma-facing surface of interest.

12. The exposure apparatus of any of claims 1-11, wherein the electrons emitted by the plasma-facing surface decelerate the high energy electrons generated in the plasma.

13. A method to suppress plasma-induced degradation on a plasma-facing surface within an enclosure of an exposure apparatus, the enclosure configured to receive a main radiation from a main radiation source and to contain a plasma, the method comprising:
receiving the main radiation, the main radiation interacting with a residual gas in the enclosure and generating the plasma;
generating an additional radiation with a wavelength of 300nm or more, wherein at least a portion of the additional radiation is configured to irradiate the plasma-facing surface to generate electrons.

14. The method of claim 13, wherein the additional radiation has a wavelength of 400nm or more, and/or shorter than 2um.

15. The method of claims 13 or 14, wherein the additional radiation is pulsed.

16. The method of any of claims 13-15, wherein the main radiation is EUV radiation, or soft x-ray radiation, or charged particles radiation, or electron beam radiation.
